# EUROPÄISCHE PATENTSCHRIFT

(11) **EP 1 987 549 B1**
(45) Veröffentlichungstag und Bekanntmachung des Hinweises auf die Patenterteilung: **26.12.2012**
(21) Anmeldenummer: 07722901.1
(22) Anmeldetag: 22.02.2007
(51) Int. Cl.: F24J 2/10, F24J 2/14, F24J 2/16, F24J 2/26, F24J 2/52, H01L 31/042, H01L 31/052

(54) **Solarmodulsystem vom Parabolkonzentratortyp**
Solar module system of the parabolic concentrator type
Système de module solaire de type concentrateur parabolique

(30) Priorität: 23.02.2006 DE 102006009412
(43) Veröffentlichungstag der Anmeldung: 05.11.2008
(73) Patentinhaber: Klotz, Fritz, 73635 Rudersberg (DE)
(72) Erfinder: KLOTZ, Fritz, 73635 Rudersberg (DE)
(74) Vertreter: Patentanwälte Ruff, Wilhelm, Beier, Dauster & Partner
(86) Internationale Anmeldenummer: PCT/EP2007/001525
(87) Internationale Veröffentlichungsnummer: WO 2007/096158

(56) Entgegenhaltungen:
- US-A- 4 674 244
- US-A- 5 180 441
- US-A- 5 344 496

## Beschreibung

Die Erfindung bezieht sich auf ein Solarmodulsystem vom Parabolkonzentratortyp mit einer Tragstruktur und wenigstens einem an der Tragstruktur anzuordnenden Solarmodul- oder Reflektorelement. Derartige Solarmodulsysteme sind als Photovoltaiksysteme und thermische Solarkollektorsysteme in unterschiedlichsten Ausführungen gebräuchlich. Vereinfachend sind vorliegend mit dem Begriff Solarmodul sowohl Photovoltaikmodule als auch thermische Solarkollektormodule umfasst.

In der Offenlegungsschrift DE 100 41 271 A1 ist eine Dachdeckung oder Wandverkleidung aus selbsttragenden Metallblechpaneelen offenbart, auf die außenseitig ein durch eine äußere Deckschicht aus lichtdurchlässigem Kunststoff geschütztes Photovoltaikmodul aufgebracht ist. Ein System mit geregelter Wärmeabfuhr und/oder Wärmezufuhr ist unterseitig an den Metallblechpaneelen in wärmeleitendem Kontakt zu diesen gehalten. Das Photovoltaikmodul kann als flexible Verbundfolie vollflächig auf das jeweilige Metallblechpaneel aufgebracht sein. Ähnliche Photovoltaikmodullaminate zum flächigen Anbringen auf einer Trägerschicht durch Verpressen oder Verkleben bzw. in selbstklebender Ausführung sind in der Offenlegungsschrift WO 01/67523 A1 und der Patentschrift US 6.553.729 B1 beschrieben.

In der Offenlegungsschrift GB 2 340 993 A ist ein Photovoltaikaufbau beschrieben, bei dem ein Modulträger aus einer unteren, ebenen Stahlplatte, einer im Abstand davon unter Zwischenfügung eines Isolationsmaterials angeordneten Stahlplatte, die kanalbildend wellenförmig profiliert ist, und einer auf dieser aufgesetzten, oberen ebenen Stahlplatte gebildet ist und ein Photovoltaik-Flachmodul auf die obere Stahlplatte aufgebracht ist. Die zwischen der kanalbildend profilierten Stahlplatte und der oberen Stahlplatte gebildeten Hohlkanäle fungieren als Kühlkanäle.

Bekanntermaßen sind außer nicht-konzentrierenden Flachmodulsystemen auch konzentrierende Solarmodulsysteme gebräuchlich, z.B. vom sogenannten V-Trog-Typ; siehe z.B. die Offenlegungsschrift US 2003/0201007 A1 und WO 2004/114419 A1, und vom Parabolkonzentratortyp, siehe z.B. die Konferenzbandbeiträge C. K. Weatherby et. al., Further Development and Field Test Results of Two Low-Material-Cost Parabolic-Trough PV Concentrators, 2nd World Conference and Exhibition on Photovoltaic Solar Energy Conversion, 6. bis 10. Juli 1998, Wien, Österreich, Seite 2189 und F. Dobon et. al., Controlled Atmosphere PV Concentrator (CAC), 17th Europcan Photovoltaic Solar Energy Conference, 22. bis 26. Oktober 2001, München, Deutschland, Seite 668.

In der Offenlegungsschrift DE 2557296 A1 ist ein Solarmodulsystem vom Parabolkonzentratortyp primär für Raumfahrtanwendungen offenbart, bei dem mehrere nebeneinander angeordnete Parabolspiegelstreifen in einer Rahmenkonstruktion mit Seitenwänden und Querleisten gehaltert sind, wobei die Rahmenkonstruktion ihrerseits an einer Querseite über eine Haltevorrichtung beweglich an einem Satellitenkörper gelagert ist. An der Rückseite jedes Spiegelstreifens sind Solarzellenstreifen thermisch leitend befestigt. Die Spiegelstreifen sind auf ihrer Rückseite wärmeabsfrahlend ausgelegt, um die Solarzellenstreifen zu kühlen.

Ein ähnliches Solarmodulsystem für Raumfahrtanwendungen ist in der Patentschrift US 5.344.496 offenbart. Beim dortigen System sind ebenfalls Parabolspiegelstreifen neben- bzw. hintereinander in einer Rahmenkonstruktion aus Seitenwänden angeordnet und an ihrer Rückseite mit einem jeweiligen Solarzellenstreifen versehen. In einer Ausführungsform sind die hintereinanderliegenden Spiegelstreifen einteilig von einem wellblechartigen Reflektorelement gebildet, dessen eine Wellenflanken die Parabolspiegelflächen mit rückseitig montiertem Solarzellenstreifen bilden und dessen andere Wellenflanken mit je einer schlitzförmigen Ausnehmung versehen sind, damit das reflektierte Licht durch die Schlitze hindurch auf die Solarzellenstreifen trifft. In einer anderen Ausführungsform sind die Spiegelelemente als Einzelelemente mit einer Aufkantung entlang der unteren Seitenkante und einer rückwärtigen Umkantung an der oberen Seitenkante ausgebildet und hintereinander in einen Trog mit Boden- und Seitenwänden so eingesetzt, dass zwischen der oberseitigen Umkantung eines Elementes und der unterseitigen Aufkantung eines nächsten Elementes ein Schlitz offen bleibt, damit reflektiertes Licht durch diesen Schlitz hindurch auf einen jeweils rückseitig angebrachten Solarzellenstreifen fallen kann.

Der Erfindung liegt als technisches Problem die Bereitstellung eines Solarmodulsystems der eingangs genannten Art zugrunde, das sich mit vergleichsweise geringem Fertigungsaufwand realisieren lässt und sich auch für relativ großflächige Anlagen von Großkraftwerken, im Freiland und zur Gebäudeintegration auf Dächern und Fassaden eignet.

Die Erfindung löst dieses Problem durch die Bereitstellung eines Solarmodulsystems mit den Merkmalen des Anspruchs 1. Dieses Solarmodulsystem ist speziell als Parabolkonzentratorsystem ausgelegt, bei dem mehrere Tragprofile in Form von selbsttragenden Hohlkammerprofilen nebeneinander angeordnet sind, wobei das Hohlkammerprofil eine vorderseitige Reflektorfunktionsfläche und eine vorderseitenabgewandte Solarmodulfunktionsfläche umfasst. Damit lassen sich z.B. Konzentratorsysteme vom Parabolrefektortyp in relativ einfacher Weise realisieren, indem vorderseitig einfallende Strahlung von einem jeweiligen Reflektorelement eines Tragprofils konzentrierend auf ein vorderseitenabgewandtes Solarmodul eines benachbarten Tragprofils reflektiert wird. Unter dem Begriff "selbsttragend" ist dabei vorliegend, wie dem hier maßgeblichen Fachmann geläufig, eine Gestaltung des Tragprofils gemeint, die so gewählt ist, dass sich das Tragprofil mit dem oder den darauf angebrachten Elementen über eine gewisse Spannweite von in den vorliegenden Anwendungsfälllen von Solarmodulsystemen typischerweise bis zu mehreren Metern, z.B. zwischen ca. 2m und 10m, selbst trägt, ohne dazu zwingend eine engmaschigere Unterkonstruktion zu benötigen, und zwar einschließlich der einzukalkulierenden Tragbelastungen im Betrieb, hier insbesondere durch Wind- und Schneelasten. Das so verstandene Tragprofil kommt folglich ohne Unterkonstruktions-Längsträger aus und benötigt bei in der Anwendung typischerweise benutzten Längen in der Regel nur einen mittigen oder zwei endseitige Träger, die in letzterem Fall typischerweise etwas eingezogen sein können, d.h. mit geringem Abstand, der viel kleiner als die Tragprofillänge ist, vom jeweiligen Tragprofil-Stirnende verlaufen.

In einer fertigungstechnisch vorteilhaften Weiterbildung der Erfindung sind gemäß Anspruch 2 die Tragprofile als Strangpressprofile-, Strangzugprofile- oder Rollformprofile gebildet.

Vorteilhafte Materialien für die Tragprofile sind im Anspruch 3 angegeben.

In Ausgestaltung der Erfindung nach Anspruch 4 ist eine Wärmeableitstruktur am Tragprofil vorgesehen, die mit der Solarmodul- und/oder Reflektorfunktionsfläche in wärmeleitender Verbindung steht. Die integrierte Wärmeableitstruktur der Tragprofile realisiert mit geringem Aufwand eine gewünschte Kühlfunktion für aufgebrachte Solarmodule und/oder Reflektorelemente. Sie kann z.B. in fertigungstechnisch einfacher Weise durch eine als integraler Teil am Tragprofil angeformte Längsrippenstruktur realisiert sein.

In Weiterbildung der Erfindung nach Anspruch 5 weist das Tragprofil einen oder mehrere Temperiermediumkanäle und/oder Leitungsdurchführungskanäle auf. Die Temperiermediumkanäle können zum Durchführen einer flüssigen oder gasförmigen Temperiermediums genutzt werden, um das Tragprofil zu kühlen oder je nach Bedarf auch zu beheizen. Die Leitungsdurchführungskanäle können zum Durchführen von elektrischen Leitungen genutzt werden.

In einer Weiterbildung der Erfindung nach Anspruch 6 ist das jeweilige Hohlkammerprofil aus mehreren längsseits zusammengesteckten Profilteilen aufgebaut. Dies kann die Fertigung ebenso wie die Montage des Systems insbesondere bei Anwendungen mit relativ großflächigen Reflektoren erleichtern.

In einer Weiterbildung der Erfindung nach Anspruch 7 weist das jeweilige Hohlkammerprofil eine in Längsrichtung durchgehende Linienfokus-Parabolreflektorfläche auf, d.h. einfallende Sonnenstrahlung wird von dieser Parabolkonzentrator-Reflektorfunktionsfläche auf eine in Tragprofillängsrichtung verlaufende Linie bzw. einen entsprechenden Streifen endlicher Breite fokussiert bzw. konzentriert. In einer alternativen Weiterbildung der Erfindung weist das jeweilige Hohlkammerprofil nach Anspruch 8 eine Mehrzahl von separaten, in Längsrichtung nebeneinander angeordneten Punktfokus-Parabolreflektorflächen auf. Jedes dieser Punktfokus-Reflektorelemente fokussiert bzw. konzentriert einfallende Strahlung auf einen Punkt bzw. einen Fleck, wo sich dementsprechend ein korrespondierendes Solarmodulelement befindet. Mit dieser alternativen Ausführungsform ist bei Bedarf ein noch höherer Konzentrationsgrad bzw. eine weitergehende Einsparung von aktiver Solarmodulfläche möglich.

Vorteilhafte Ausführungsformen der Erfindung sind in den Zeichnungen dargestellt und werden nachfolgend beschrieben. Hierbei zeigen:
- Fig. 1: einen Querschnitt durch ein Tragprofil für ein Photovoltaiksystem vom Linienfokus-Parabolkonzentratortyp,
- Fig. 2: einen Querschnitt eines Teils eines unter Verwendung der Tragprofile gemäß Fig. 1 gebildeten Photovoltaiksystems vom Parabolkonzentratortyp,
- Fig.3: eine Draufsicht auf ein Photovoltaiksystem vom Linienfokus-Parabolkonzentratortyp mit sechs nebeneinanderliegenden Tragprofilen gemäß Fig. 1,
- Fig. 4: eine Querschnittansicht längs einer Linie II - II von Fig. 3,
- Fig. 5: einen Querschnitt entsprechend Fig. 1 für eine Variante mit mehrteilig zusammengestecktem und mit Temperierkanälen versehenem Tragprofil,
- Fig. 6: einen Querschnitt entsprechend Fig. 1 für eine Variante vom Punktfokus-Parabolkonzentratortyp,
- Fig. 7: eine Draufsicht auf ein Photovoltaiksystem vom Punktfokus-Parabolkonzentratortyp mit einem Feld einzelner Punktfokus-Reflektorelemente gemäß Fig. 6 und
- Fig. 8: eine Draufsicht auf eines der Punktfokus-Reflektorelemente von Fig. 7 mit korrespondierendem Solarmodulelement.

Nachfolgend werden verschiedene Ausführungsbeispiele der Erfindung unter Bezugnahme auf die Zeichnungen näher erläutert, wobei in den Zeichnungen der Übersichtlichkeit halber identische oder funktionell äquivalente Komponenten mit jeweils gleichem Bezugszeichen versehen sind.

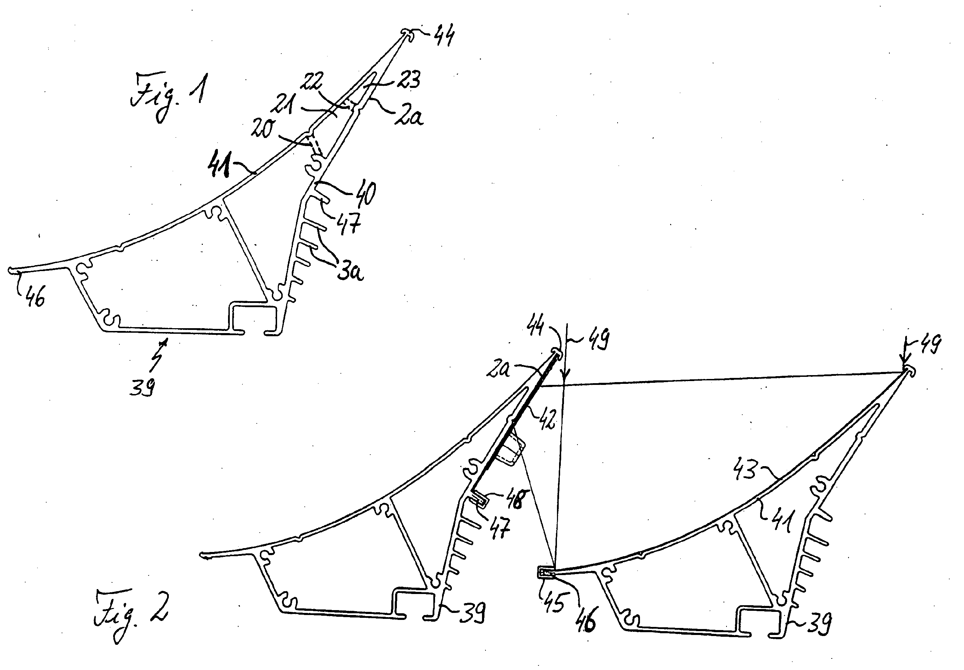

Die Fig. 1 bis 4 veranschaulichen ein Photovoltaiksystem vom Linienfokus-Parabolkonzentratortyp unter Verwendung einer Tragstruktur, die aus einer Aneinanderreihung von geeignet gestalteten, identischen Tragprofilen gebildet ist. Speziell fungiert in diesem Fall ein in Fig. 1 im Querschnitt dargestelltes, in Längsrichtung geradliniges Hohlkammerlängsprofil 39 als Tragprofil, an dem an einer rückwärtigen Profilseitenwandung 40 in einem vorderen Teil eine Modulhaltefläche 2a und in einem hinteren Teil eine Wärmeleitrippenstruktur 3a ausgebildet sind. Eine vorderseitige Profilseitenfläche 41 ist parabelförmig gekrümmt und fungiert als Reflektorhaltefläche.

Fig. 2 zeigt in Gebrauchsstellung zwei nebeneinander angeordnete Tragprofile 39. Zur Veranschaulichung der lichtkonzentrierenden Funktion ist das in Fig. 2 linke Tragprofil 39 mit einem an seiner Modulhaltefläche 2a angebrachten Solarmodul 42 gezeigt, und das in Fig. 2 rechte Tragprofil 39 ist mit einem vollflächig auf seiner parabelförmigen Reflektorhaltefläche 41 aufgebrachten Reflektorelement 43 gezeigt. Im Beispiel der Fig. 2 sind das sich in Tragprofil-Längsrichtung streifenförmig erstreckende Solarmodul 42 und das Reflektorelement 43 jeweils klemmend gehalten. Dazu ist an der vorderen Längskante des Tragprofils 39 eine doppelte Haltenasenstruktur 44 angeformt, die auf ihrer vorderen, lichteinstrahlungszugewandten Seite das Reflektorelement 43 und auf ihrer rückwärtigen Seite das Solarmodul 42 in je einer Aufnahmenut hält. Das Reflektorelement 43 ist an der anderen Längskante mittels eines Klemmprofils 45 mit U-förmigem Querschnitt gehalten, das auf einen entsprechenden Fortsatz 46 des Halteprofils 39 aufgerastet werden kann, wozu die Rückseite dieses Fortsatzes 46 und die korrespondierende Innenseite des Klemmprofils 45 mit geeigneten Rastriffelungen versehen sind. In ähnlicher Weise wird das Solarmodul 42 an seiner der Haltenase 44 entgegengesetzten Längsseite durch ein weiteres U-förmiges Klemmprofil 48 gegen die Modulanlagefläche 2a gedrückt gehalten, das auf eine korrespondierende, geriffelte Rastnase 47 des Tragprofils 39 verrastend aufgesteckt ist. Diese Rastnase 47 steht als Längssteg entsprechend den Wärmeableitrippen 3a nach außen von der zugehörigen Profilwandung 40 vor.

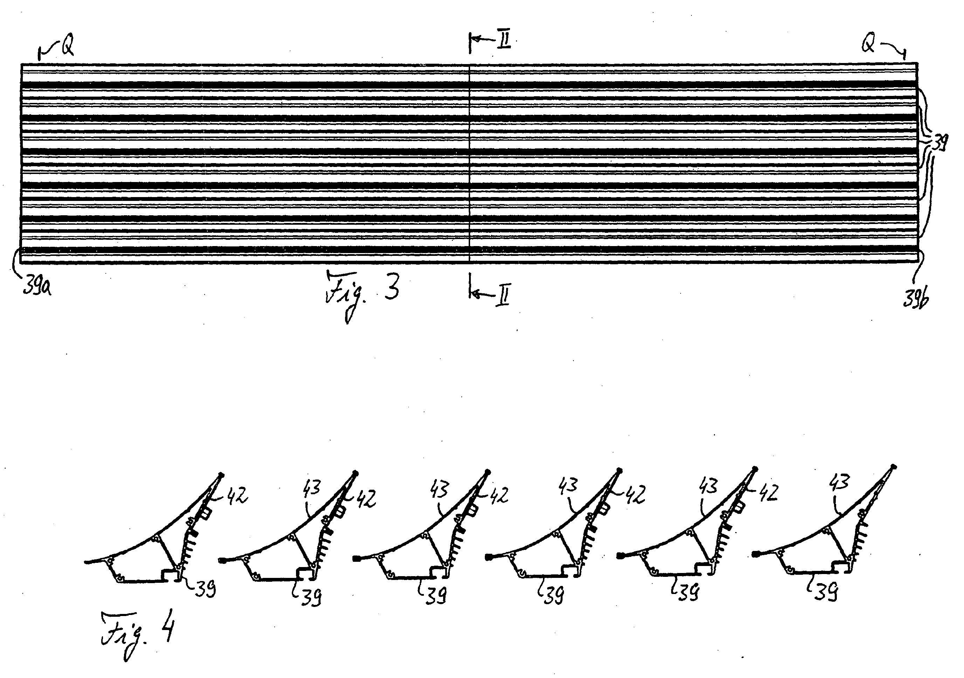

Wie in Fig. 2 illustriert, wird einfallende Lichtstrahlung 49 vom Parabolreflektor 43 linien- bzw. streifenförmig konzentrierend auf den aktiven Flächenanteil des Solarmodulelements 42 reflektiert. Die Fig. 3 und 4 zeigen in Draufsicht bzw. einer Querschnittansicht ein aus sechs Tragprofilen 39 aufgebautes Fotovoltaiksystem gemäß dieser Parabolkonzentratorvariante, wobei sich im gezeigten Beispiel ein Konzentrationsfaktor von etwa zehn ergibt.

Aufgrund der selbsttragenden Eigenschaft der Tragprofile 39 genügt zur Halterung des gesamten Aufbaus in nicht näher gezeigter Weise bereits ein etwa mittig, z.B. auf Höhe der Linie II-II von Fig. 3 angeordneter Querträger, oder es können alternativ dazu zwei endseitige Querträger im Bereich der beiden Stirnseiten 39a, 39b der Tragprofile 39 oder um einen geringen Abstand von z.B. bis zu einigen zehn Zentimetern auf einer Querträgerhöhe Q vorgesehen sein, wobei die Tragprofile 39 typische Längen zwischen etwa 2m und etwa 10m aufweisen, in Ausnahmefällen auch eine geringere oder größere Länge.

Bei Bedarf kann eine Temperierung, d.h. Kühlung oder Beheizung, des Tragprofils 39 vorgesehen sein, insbesondere im Bereich seiner Modulhaltefläche 2a. Dazu sind in diesbezüglichen Ausführungsformen jeweils ein oder mehrere Hohlkammern bzw. Hohlkanäle ausgebildet, durch die ein flüssiges oder gasförmiges Temperiermedium hindurchgeleitet werden kann. In Fig. 1 sind zwei Realisierungsmöglichkeiten unterschiedlich großer derartiger Hohlkanäle als Option gezeigt. So ist gestrichelt eine Profilzwischenwandung 20 gezeigt, mit der das Tragprofil 39 optional versehen sein kann, um einen Temperierkanal 21 angrenzend an die Modulhaltefläche 2a zu bilden. Als weitere Option ist gestrichelt eine Profilzwischenwand 22 gezeigt, durch die, wenn vorhanden, im oberen Teil des Tragprofils 39 ein kleinerer Temperierkanal 23 gebildet ist. Durch den betreffenden Temperierkanal 21 oder 23 kann ein flüssiges oder gasförmiges Kühl- oder Heizmedium hindurchgeleitet werden, um das Tragprofil 39 in diesem Bereich und insbesondere im Bereich der Modulhaltefläche 2a zu kühlen bzw. zu beheizen. Es versteht sich, dass durch entsprechende Profilzwischenwandstrukturen beliebige weitere und/oder andere Hohlkammern vorgesehen sein können, die als Kühl- oder Heizkanäle fungieren können, aber auch als Leitungsdurchführungskanäle zum Durchführen elektrischer Leitungen oder dergleichen.

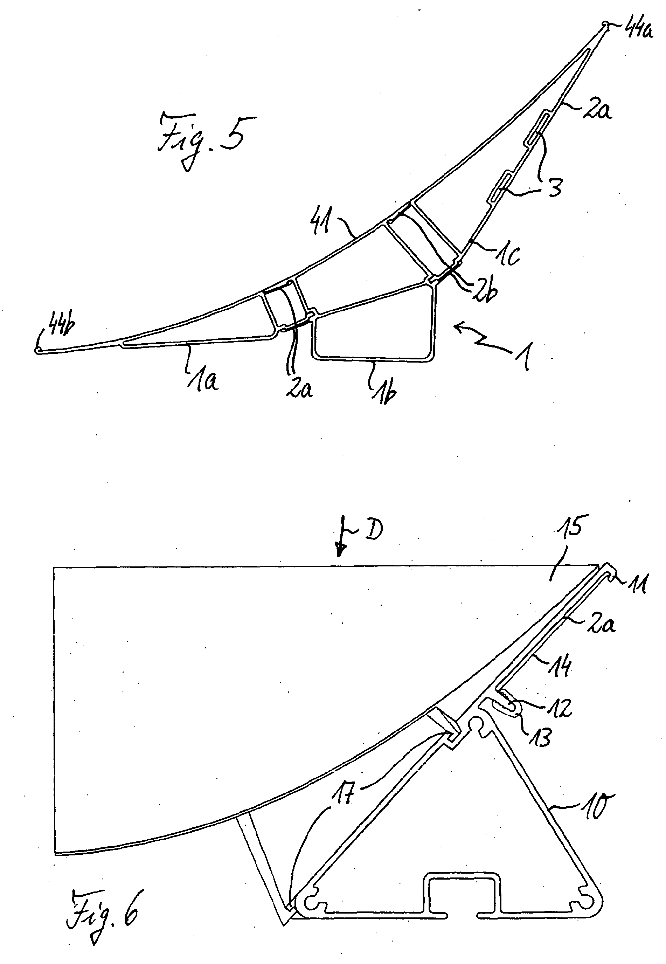

Fig. 5 zeigt eine Variante des Linienfokus-Parabolkonzentratortyps der Fig. 1 bis 4. Diese Variante beinhaltet ein modifiziertes Hohlkammerlängsprofil 1 als Tragmodul, das aus drei längsseitig zusammengesteckten Teilen 1 a, 1 b, 1 c aufgebaut ist. Dabei bildet der mittlere Teil 1 b einen Grundkörper, an dessen beiden Längsseiten je eines der beiden übrigen Teile 1a, 1 c über je eine längsverlaufende Rast-/Steckverbindung 2a, 2b angesteckt sind, wobei frontseitig die auch über die Steckverbindungen 2a, 2b hinweg bündig, glatt verlaufende Reflektorhaltefläche 41 entsteht. Zum Halten eines darauf auflegbaren Reflektorelementes dienen wiederum unter anderem geeignete Haltenasen 44a, 44b. Alle drei Tragprofilteile 1 a, 1b, 1 c sind ihrerseits als Hohlkammerprofil realisiert. Das Zusammensetzen aus drei Teilen erleichtert die Fertigung und die Montage des Tragprofils 1 insbesondere bei relativ großflächigen Ausführungen. Die für die Steckverbindungen 2a, 2b erforderlichen Steck-/Rastnasen bzw. Steck-/Rastzungen sind vorzugsweise an der betreffenden Profillängsseite angeformt.

Das Tragprofil 1 von Fig. 5 weist darüber hinaus an der Innenseite der Modulhaltefläche 2a zwei integrierte Temperierkanäle 3 auf, durch die ein flüssiges oder gasförmiges Temperiermedium hindurchgeleitet werden kann, um vor allem die Modulhaltefläche 2a des Tragprofils 1 in gewünschter Weise zu kühlen oder zu beheizen.

Die Fig. 6 bis 8 veranschaulichen ein Solarmodulsystem vom Punktfokus-Parabolkonzentratortyp, das ebenso wie die Ausführungsbeispiele zu den Fig. 1 bis 5 unter Aneinanderreihung von geeignet gestalteten, identischen Hohlkammerlängsprofilen 10 als Tragprofilen realisiert ist. Auch dieses Tragprofil 10 weist in einem oberen, rückwärtigen Profilwandbereich eine Modulhaltefläche 2a auf, an der unter Verwendung einer oberseitigen Haltenase 11 und einem unterseitigen Klemmprofil 12 mit aufgesteckter Klemmhalteleiste 13 ein Solarmodulelement 14 gehalten ist.

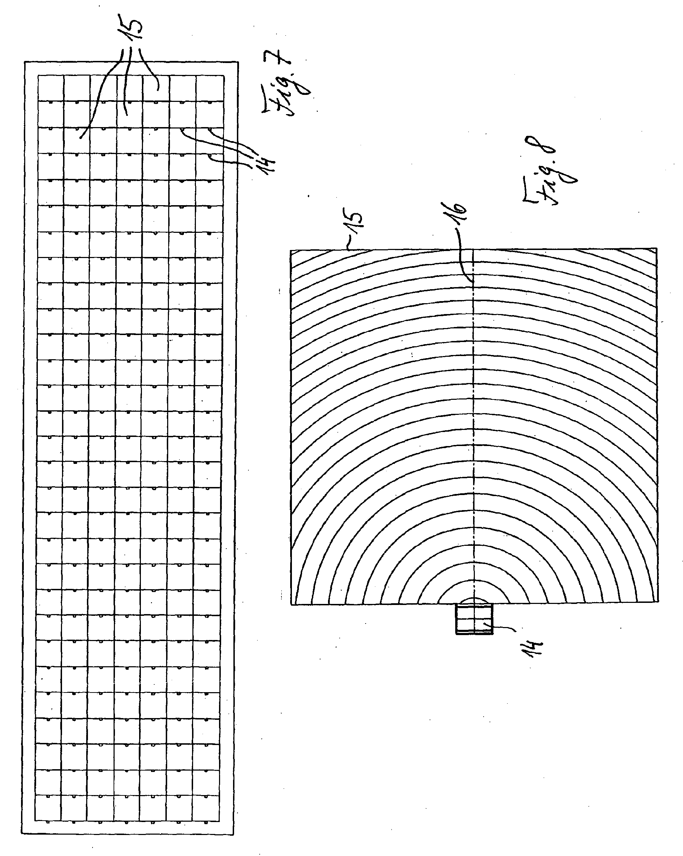

Im Unterschied zu den Linienkonzentratortypen der Fig. 1 bis 5 ist die gesamte effektive Parabolreflektorfläche, die einem der mehreren nebeneinanderliegenden Tragprofile 10 zugeordnet ist, nicht von einer in Tragprofillängsrichtung durchgehenden Fläche gebildet, sondern von einer Mehrzahl von in Längsrichtung nebeneinander am Tragprofil 10 vorgesehenen einzelnen Parabolreflektorelementen 15 gebildet. In Fig. 6 ist ein einzelnes solches Reflektorelement 15 in einem Längsschnitt längs einer in Fig. 8 wiedergegebenen Längsebene 16 dargestellt, während Fig. 8 ein einzelnes Reflektorelement 15 in einer Draufsicht zeigt, d.h. in einer Ansicht längs eines Pfeils D von Fig. 6. Zur Verdeutlichung sind in Fig. 8 zugehörige Niveaulinien eingezeichnet. Das einzelne kalottenförmige Reflektorelement 15 mit im gezeigten Beispiel etwa quadratischem Grundriss bewirkt durch seine Paraboloid-Kalottenform eine punkt- bzw. fleckartige Fokussierung bzw. Konzentration der einfallenden Sonnenstrahlung auf das jeweils zugehörige Solarmodulelement 14, das sich wie bei den Ausführungsbeispielen der Fig. 1 bis 5 an der Rückseite des jeweils vorgelagerten Tragprofils 10 befindet.

Wie aus Fig. 6 weiter ersichtlich, sind die einzelnen Reflektorelemente 15 durch eine Steck-/Rastverbindung 17 an der Tragprofilvorderseite gehalten, die dazu mit einer passenden Steck-/Rastverbindungsprofilierung versehen ist. Im Unterschied zu den Ausführungsbeispielen der Fig. 1 bis 5 ist folglich beim Ausführungsbeispiel der Fig. 6 bis 8 die effektive Reflektorfläche, d.h. die Innenfläche der Reflektorelemente 15, an der Tragprofilvorderseite montiert und nicht direkt von einer Tragprofilvorderseite gebildet.

Fig. 7 zeigt in Analogie zu Fig. 3 eine typische Anordnung aus einem zweidimensionalen, matrixförmigen Feld solcher Punktfokus-Reflektorelemente 15 in Draufsicht, wobei die zugehörigen, darunter liegenden Tragprofile in der Draufsicht von Fig. 7 nicht zu sehen sind. Sie verlaufen in Zeilenrichtung, d.h. für das Reflektorelementfeld von Fig. 7 mit den sieben Reflektorelementzeilen sind entsprechend sieben Tragprofile 10 hintereinander angeordnet, wobei in Zeilenrichtung die zugehörigen Reflektorelemente 15 nebeneinander auf dem betreffenden Tragprofil montiert sind.

Wie Fig. 7 weiter zeigt, sind die einzelnen Punktfokus-Reflektorelemente 15 praktisch lückenlos in Zeilen- und Spaltenrichtung nebeneinander angeordnet. Wenngleich an sich nicht zu erkennen, da an der Tragprofilrückseite montiert, sind in Fig. 7 zum besseren Verständnis die zugehörigen Solarmodulelemente 14 an ihren entsprechenden Positionen gezeigt.

Wie oben zum Ausführungsbeispiel der Fig. 3 beschrieben, genügt zur Befestigung des Aufbaus von Fig. 7 je nach Bedarf und speziellem Anwendungsfall bereits ein mittiger Querträger, der die einzelnen Tragprofile 10 in ihrem Längsmittenbereich stützt, oder zwei stirnendseitige, optional etwas eingezogene Querträger.

Da beim Ausführungsbeispiel der Fig. 6 bis 8 durch das Punktfokussierungsverhalten eine Lichtkonzentration auch in Tragprofillängsrichtung bewirkt wird, ergibt sich ein bei ansonsten analoger Auslegung höherer Konzentrationsgrad gegenüber dem Linienfokustyp, so dass bei gleicher effektiver Reflektorfläche der Bedarf an benötigter Solarmodulfläche gegenüber dem Linienfokustyp weiter reduziert werden kann. Mit anderen Worten genügen bei der Anordnung der Fig. 6 bis 8 bereits vergleichsweise kleinflächige, einzelne Solarmodulelemente 14, die in Tragprofillängsrichtung mit Abstand voneinander am jeweiligen Tragprofil 10 montiert sind. Ein in Längsrichtung durchgehender Solarmodulstreifen ist zur Nutzung der gesamten reflektierten Strahlung nicht zwingend erforderlich.

In einer alternativen Ausführungsform können die einzelnen Solarmodulelemente 14 statt an einer Tragprofilrückseite auch direkt an der Rückseite der einzelnen, am jeweiligen Tragprofil montierten Reflektorelemente 15 angebracht sein. Das Tragprofil weist dann im entsprechenden Bereich keine Profilwandung auf bzw. allenfalls eine transparente Wandung, damit das von einem auf dem nächsten Tragprofil montierten Reflektorelement reflektierte Licht ungehindert auf das Solarmodulelement an der Rückseite des davor liegenden Reflektorelements fallen kann.

Wie anhand der gezeigten und oben erläuterten Ausführungsbeispiele deutlich wird, stellt die Erfindung ein kombiniertes Trag- und Kühlprofil bereit, das vergleichsweise einfach herstellbar ist, selbsttragend als Hohllängsprofil gestaltet ist und einen Temperierkanal und/oder eine angeformte Wärmeableitstruktur beinhalten kann, die mit einer Modulhaltefläche und/oder einer Reflektorfunktionsfläche in wärmeleitender Verbindung steht, so dass von dort effektiv Wärme abgeführt werden kann. Die dadurch erzielbare Absenkung der Betriebstemperatur aufgebrachter Solarmodule ermöglicht einen energetischen Mehrertrag. Dies gilt sowohl für Photovoltaikzellen aus kristallinem Silizium als auch für Dünnschichtsolarzellen auf einem Folien-, Blech- oder Membranträger. Die Tragprofile sind sehr einfach und kostengünstig z.B. durch Strangpressen, Strangziehen oder Rollformen aus wärmeleitendem Material herstellbar, wie Aluminium, Magnesium, Edelstahl, verzinktem Stahl oder einem wärmeleitenden Kunststoffmaterial. Das erfindungsgemäße Tragstrukturkonzept ermöglicht einen sehr hohen Vorfertigungs- bzw. Vormontagegrad für entsprechende Photovoltaiksysteme. Es versteht sich, dass die Erfindung in gleicher Weise für thermische Solarkollektorsysteme anwendbar ist.

Das erfindungsgemäße Tragstrukturkonzept eignet sich für großflächige integrierte Photovoltaiksysteme in Großkraftwerken ebenso wie im Freiland und zur Gebäudeintegration. Dach- oder Fassadenelemente einschließlich Beschattungslamellenanlagen können ohne aufwändige Unterkonstruktion mit relativ geringem Montageaufwand installiert werden, z.B. als Gebäudehaut. Es wird eine hohe Modularität solcher Fassaden- und Dachsysteme erzielt, die primär an den baulichen Randbedingungen orientiert werden kann, wie Fassadenraster, Stockwerkshöhe etc.

Besonders vorteilhaft lassen sich durch Kombination von Tragprofilen aus Aluminium, die z.B. als Strangzugelemente gefertigt sind, mit photovoltaischen Folienlaminaten selbsttragende Photovoltaikmoduleinheiten mit relativ niedrigem Gewicht und hoher Stabilität und insbesondere Längssteifigkeit realisieren.

In allen Anwendungsfällen stellt die Erfindung eine einfach herstellbare Tragstruktur mit kombiniertem Trag-/Kühlprofil bereit, das eine vergleichsweise hohe Torsions- und Biegesteifigkeit und hohe Mindeststützweite aufweist. Das Trag-/Kühlprofil übernimmt die vollständige Tragfunktion für die aufgebrachten Solarmodul- und/oder Reflektorelemente, die z.B. durch geeignete Klemmungen, Fügetechniken und/oder Verklebungen darauf befestigt werden. Gleichzeitig fungiert das Tragprofil als Wärmesenke.

Die Tragprofile werden stirnseitig z.B. über integrierte Schraubkanäle und/oder an Nutkanälen in Form einer eingezogenen Befestigung mit geeigneten, üblichen Querträgern bei Bedarf zu größeren Trageinheiten verbunden.

Die Solarmodule werden vorzugsweise mit transparenten Frontfolien anstelle von Frontgläsern versehen, was Vorteile hinsichtlich Wärmeausdehnungskoeffizient, Gewicht, Bruchgefahr und Formateinschränkung hat, und in gutem Wärmekontakt mit dem darunter liegenden Tragprofil verbunden, z.B. durch direktes Auflaminieren oder indirekt durch Aufkleben oder Aufklemmen von vorlaminierten Einheiten, z.B. glaslosen Photovoltaiklaminaten.

Bei der statischen Integration in die Gebäudehaut können die Tragprofile zu größeren, auf das Gebäuderaster abgestimmten Trageinheiten vormontiert und dann mit einem Photovoltaik-Folienverbund als Solarmodul durch Laminieren, Kleben etc. versehen werden. Bei nachgeführten Systemen werden die Trageinheiten an entsprechenden Querträgern drehbeweglich gelagert. In entsprechenden Ausführungsformen werden mehrere Trageinheiten über geeignete Kopplungselemente, wie Zug-Druck-Gestänge, zu größeren Systemeinheiten zusammengefasst und durch einen gemeinsamen Antrieb dem Lichteinfall nachgeführt. Beispielsweise können zehn oder mehr Dreheinheiten mit jeweils ca. 7,5m² Solarmodulfläche zu einem aufgeständerten Teilsystem verbunden werden. Derartige aufgeständerte Anlagen sind sowohl im Freiland als auch auf Flach- und Schrägdächern installierbar.

In einer weiteren vorteilhaften Ausführungsform mit Aufständerung werden die Tragprofile zwecks Solarnachführung zu großen Tischeinheiten zusammengesetzt und über eingezogene Querträger mit einer zentralen Drehvorrichtung mit vertikaler Drehachse verbunden. In dieser besonders für das Freiland geeigneten Anordnung sind Dreheinheiten bzw. Teilsysteme von mehr als 100m² Solarmodulfläche realisierbar. In einer weiter optimierten Aufständerungsform sind die Drehtische auch in ihrer Neigung schwenkbar, so dass eine zweiachsige Sonnenstandsnachführung möglich ist.

Es sei nochmals betont, dass durch die erfindungsgemäße Realisierung der Tragprofile als selbsttragendes Hohllängsprofil eine Abstützung der damit aufgebauten Tragstrukturen in den Stirnseitenbereichen ausreicht und weitere Querverstrebungen zwischen der stirnseitigen Halterung bzw. Lagerung der solchermaßen aufgebauten Tragstrukturen nicht zwingend benötigt werden. Denn die Tragprofile weisen durch ihre Hohlprofilstruktur eine ausreichende selbsttragende Längssteifigkeit bei vergleichsweise niedrigem Eigengewicht auf.

## Patentansprüche

1. Solarmodulsystem vom Parabolkonzentratortyp mit
- einer selbsttragend ausgelegten Tragstruktur (39) und
- wenigstens einem an der Tragstruktur anzuordnenden Solarmodulelement oder Reflektorelement,
**dadurch gekennzeichnet, dass**
- die Tragstruktur mehrere nebeneinander angeordnete Tragprofile in Form von selbsttragenden Hohlkammerprofilen (39) mit vorderseitiger Parabolkonzentrator-Reflektorfunktionsfläche (41) und vorderseitenabgewandter Solarmodulfunktionsfläche (2a) aufweist.

2. Solarmodulsystem nach Anspruch 1, weiter **dadurch gekennzeichnet, dass** das Tragprofil als Strangpress-, Strangzug- oder Rollformprofil gebildet ist.

3. Solarmodulsystem nach einem der Anspruch 1 oder 2, weiter **dadurch gekennzeichnet, dass** das Tragprofil aus Aluminium, Magnesium, Edelstahl, einem verzinkten Stahlmaterial oder einem wärmeleitenden Kunststoffmaterial gebildet ist.

4. Solarmodulsystem nach einem der Ansprüche 1 bis 3, weiter **dadurch gekennzeichnet, dass** das Tragprofil eine mit seiner Solarmodulfunktionsfläche und/oder seiner Reflektorfunktionsfläche in wärmeleitender Verbindung stehende Wärmeableitstruktur (3a) aufweist.

5. Solarmodulsystem nach einem der Ansprüche 1 bis 4, weiter **dadurch gekennzeichnet, dass** das Tragprofil einen oder mehrere Temperiermediumkanäle und/oder Leistungsdurchführungskanäle aufweist.

6. Solarmodulsystem nach einem der Ansprüche 1 bis 5, weiter **dadurch gekennzeichnet, dass** das jeweilige Hohlkammerprofil aus mehreren längsseits zusammengesteckten Profilteilen (1 a, 1b, 1c) aufgebaut ist.

7. Solarmodulsystem nach einem der Ansprüche 1 bis 6, weiter **dadurch gekennzeichnet, dass** das jeweilige Hohlkammerprofil eine in Längsrichtung durchgehende Linienfokus-Parabolreflektorfläche (41) als Parabolkonzentrator-Reflektorfunktionsfläche aufweist.

8. Solarmodulsystem nach einem der Ansprüche 1 bis 6, weiter **dadurch gekennzeichnet, dass** das jeweilige Hohlkammerprofil eine Mehrzahl von separaten, in Längsrichtung nebeneinander angeordneten Punktfokus-Parabolreflektorflächen (15) als Parabolkonzentrator-Reflektorfunktionsfläche aufweist.

## Claims

1. A solar module system of the parabolic concentrator type having
- a self-supporting support structure (39) and
- at least one solar module element or reflector element which can be arranged on the support structure,
**characterized in that**
- the support structure has a plurality of support profiles, which are arranged alongside one another, in the form of self-supporting hollow-chamber profiles (39) with a parabolic concentrator reflector functional area (41) on the front face, and a solar module functional area (2a) averted from the front face.

2. The solar module system according to claim 1, further **characterized in that** the support profile is in the form of an extruded, strand-drawn or roll-formed profile.

3. The solar module system according to claim 1 or 2, further **characterized in that** the support profile is formed from aluminium, magnesium, stainless steel, a galvanized steel material or a thermally conductive plastic material.

4. The solar module system according to any of claims 1 to 3, further **characterized in that** the support profile has a heat dissipation structure (3a) which is thermally conductively connected to its solar module functional area and/or to its reflector functional area.

5. The solar module system according to any of claims 1 to 4, further **characterized in that** the support profile has one or more heating or cooling medium ducts and/or power supply ducts.

6. The solar module system according to any of claims 1 to 5, further **characterized in that** each hollow-chamber profile is formed from a plurality of profiled parts (1a, 1b, 1c) which are plugged together on the longitudinal side.

7. The solar module system according to any of claims 1 to 6, further **characterized in that** each hollow-chamber profile has a line-focus parabolic reflector surface (41), which is continuous in the longitudinal direction, as the parabolic concentrator reflector functional area.

8. The solar module system according to any of claims 1 to 6, further **characterized in that** each hollow-chamber profile has a plurality of separate point-focus parabolic reflector surfaces (15), which are arranged alongside one another in the longitudinal direction, as the parabolic concentrator reflector functional area.

## Revendications

1. Système de module solaire de type concentrateur parabolique avec
- une structure porteuse (39) conçue de manière autoportante, et
- au moins un élément de module solaire ou élément réflecteur à disposer sur la structure porteuse,
**caractérisé en ce que**
- la structure porteuse présente plusieurs profilés porteurs disposés les uns à côté des autres sous forme de profilés creux (39) autoportants avec une surface fonctionnelle de réflecteur de concentrateur parabolique (41) sur la face avant et une surface fonctionnelle de module solaire (2a) sur la face opposée.

2. Système de module solaire selon la revendication 1, **caractérisé par** ailleurs en ce que le profilé porteur est conçu sous forme de profilé extrudé, étiré ou roulé.

3. Système de module solaire selon la revendication 1 ou 2, **caractérisé par** ailleurs en ce que le profilé porteur est constitué d'aluminium, de magnésium, d'acier spécial, d'un matériau à base d'acier galvanisé ou d'un matériau synthétique thermoconducteur.

4. Système de module solaire selon l'une des revendications 1 à 3, **caractérisé par** ailleurs en ce que le profilé porteur présente une structure de dissipation de la chaleur (3a) en liaison thermoconductrice avec sa surface fonctionnelle de module solaire et/ou sa surface fonctionnelle de réflecteur.

5. Système de module solaire selon l'une des revendications 1 à 4, **caractérisé par** ailleurs en ce que le profilé porteur présente un ou plusieurs canaux pour un fluide régulateur de température et/ou des canaux de transmission de puissance.

6. Système de module solaire selon l'une des revendications 1 à 5, **caractérisé par** ailleurs en ce que chaque profilé creux est constitué de plusieurs parties de profilé (1a, 1b, 1c) emboîtées dans le sens longitudinal.

7. Système de module solaire selon l'une des revendications 1 à 6, **caractérisé par** ailleurs en ce que chaque profilé creux présente une surface de réflecteur parabolique à foyer linéaire (41) continue dans le sens longitudinal en tant que surface fonctionnelle de réflecteur de concentrateur parabolique.

8. Système de module solaire selon l'une des revendications 1 à 6, **caractérisé par** ailleurs en ce que chaque profilé creux présente plusieurs surfaces de réflecteur parabolique à foyer ponctuel (15) séparées disposées les unes à côté des autres dans le sens longitudinal en tant que surface fonctionnelle de réflecteur de concentrateur parabolique.
